# EUROPÄISCHE PATENTSCHRIFT

(11) **EP 0 395 153 B1**
(45) Veröffentlichungstag und Bekanntmachung des Hinweises auf die Patenterteilung: **21.12.1994**
(21) Anmeldenummer: 90200996.8
(22) Anmeldetag: 20.04.1990
(51) Int. Cl.: G01R 19/145

(54) **Schaltungsanordnung zum Überwachen von zwei Betriebsspannungen**
Circuit for supervising two operation voltages
Circuit pour surveiller deux tensions de fonctionnement

(30) Priorität: 26.04.1989 DE 3913666
(43) Veröffentlichungstag der Anmeldung: 31.10.1990
(73) Patentinhaber: Philips Patentverwaltung GmbH, 22335 Hamburg (DE); Philips Electronics N.V., 5621 BA Eindhoven (NL)
(72) Erfinder: Schemmel, Hans-Robert, D-8500 Nürnberg (DE)
(74) Vertreter: Peuckert, Hermann, Dipl.-Ing.

(56) Entgegenhaltungen:
- DE-A- 2 935 483
- DE-B- 1 182 741
- DE-B- 2 526 346
- PATENT ABSTRACTS OF JAPAN vol. 12, no. 245 (P-729)(3092) 12 Juli 1988,& JP-A-63 37262

## Beschreibung

### Schaltungsanordnung zum Überwachen von zwei Betriebsspannungen

Die Erfindung betrifft eine Schaltungsanordnung zum Überwachen von zwei Betriebsspannungen unterschiedlicher Polarität gemäß dem Gattungsbegriff.

Eine derartige schaltungsanordnung wird insbesondere bei Geräten der Nachrichten- und Datentechnik benötigt, um zu verhindern, daß beim Abweichen einer Betriebsspannung von ihrem Sollwert über eine bestimmte Toleranzgrenze beispielsweise fehlerhafte Daten ausgegeben werden, ohne daß dies rechtzeitig erkannt wird. Daher soll der Ausfall oder die Störung einer Betriebsspannung sicher angezeigt oder das Gerät automatisch abgeschaltet werden.

Aus DE-B 25 26 346 ist eine Schaltungsanordnung zum Überwachen des Ausfalls einer von mehreren für den Betrieb von elektronischen Geräten erforderlichen Betriebsspannungen unterschiedlicher Polarität bekannt. Die Schaltungsanordnung weist eine gemeinsame Bezugsleitung und ein Überwachungsrelais auf, das in den Stromkreis einer der zu überwachenden Spannungen eingeschaltet ist und beim Ausfall einer der zu überwachenden Spannungen abfällt und eine Anzeige auslöst. Das Relais ist in Reihe zu einem Schalttransistor angeordnet, dessen Basis an einer Zenerdiode angeschlossen ist. Sinkt die Spannung an der Anode der Zenerdiode unter 0 Volt, so wird der Schalttransistor gesperrt und das Relais fällt ab.

Der Erfindung liegt die Aufgabe zugrunde, eine Schaltungsanordnung der eingangs genannten Art anzugeben, die mit geringem Bauteilaufwand einfach und kostengünstig realisiert werden kann, einen geringen Leistungsbedarf, wählbare Toleranzgrenzen und eine hohe Genauigkeit aufweist und bei beiden Betriebsspannungen sicher anspricht.

Diese Aufgabe wird bei einer Schaltungsanordnung der eingangs genannten Art durch die kennzeichnenden Merkmale des Hauptanspruchs gelöst.

Vorteilhafte Ausgestaltungsformen sind in den Unteransprüchen enthalten.

Die Schaltungsanordnung ermöglicht bei sehr geringem Aufwand an Bauteilen sowie geringem Leistungsbedarf eine sichere Überwachung von zwei Betriebsspannungen.

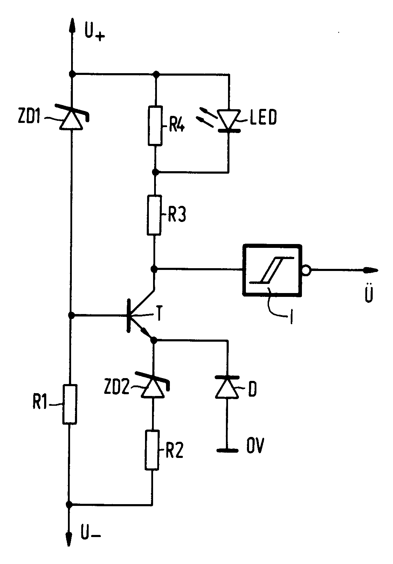

Im folgenden wird die Erfindung anhand eines in der Figur dargestellten Ausführungsbeispieles näher erläutert.

Die Figur zeigt eine Schaltungsanordnung zum Überwachen von zwei Betriebsspannungen.

Die Figur zeigt eine Schaltungsanordnung zum Überwachen einer positiven Betriebsspannung U+ und einer negativen Betriebsspannung U-. Die positive Betriebsspannung U+ ist mit der Kathode einer ersten Zenerdiode ZD1 verbunden. Die Anode der Zenerdiode ZD1 ist mit der Basis eines Transistors T kontaktiert. Die negative Betriebsspannung U- ist bei dem in der Figur dargestellten Ausführungsbeispiel über die Reihenschaltung eines zweiten Widerstandes R2 und einer zweiten Zenerdiode ZD2 mit dem Emitter des Transistors T verbunden, wobei die Kathode der Zenerdiode Z2 mit dem Emitter des Transistors T kontaktiert ist. Der Emitter des Transistors T ist darüber hinaus mit der Kathode einer auf Massepotential OV geschalteten Diode D verbunden. Zwischen der Basis des Transistors T und der negativen Betriebsspannung U- ist ein erster Widerstand R1 angeordnet. Der Kollektor des Transistors T ist über einen Widerstand R3 und einen dazu in Reihe liegenden weiteren Widerstand R4 mit der positiven Betriebsspannung U+ verbunden. Parallel zum Widerstand R4 ist eine als Anzeigevorrichtung dienende Leuchtdiode LED angeordnet. Der Kollektor des Transistors T ist darüber hinaus mit einer Überwachungseinrichtung verbunden, die ein Überwachungssignal Ü abgibt. Bei dem in der Figur dargestellten Ausführungsbeispiel wird die Überwachungseinrichtung aus einem Inverter I mit Hysterese gebildet, der aus der am Kollektor des Transistors T anliegenden Spannung ein Überwachungssignal Ü bildet.

Bei einer praktisch ausgeführten Schaltungsanordnung beträgt die positive Betriebsspannung + 5 Volt, die negative Betriebsspannung - 12 Volt. Dabei ist die Zenerspannung der Zenerdiode ZD1 mit 4,7 Volt und die der Zenerdiode ZD2 mit 8,2 Volt dimensioniert.

Sind die Betriebsspannungen U+, U- bei dem in der Figur dargestellten Ausführungsbeispiel ungestört, so erfolgt durch die in Sperrichtung vorgespannten Zenerdioden ZD1, ZD2 ein Stromfluß über die Widerstände R1, R2. Der Widerstandswert des Widerstandes R1 beträgt bei der praktisch ausgeführten Schaltungsanordnung ca. 4 kOhm, der des Widerstandes R2 ca. 200 Ohm. Der Transistor T ist somit leitend, d.h., die Leuchtdiode LED leuchtet auf und zeigt so den ungestörten Betriebszustand an. Die am Kollektor des Transistors T auftretende positive Spannung wird dem beim Ausführungsbeispiel als Schmitt-Trigger mit Hysterese realisierten Inverter I zugeführt, so daß das digitale Überwachungssignal Ü nicht ausgelöst wird. Der Widerstand R3 ist bei der praktisch ausgeführten Schaltungsanordnung mit ca. 200 Ohm und der Widerstand R4 mit ca. 1 kOhm dimensioniert. Als Inverter kommt beispielsweise der HCMOS-Baustein 74HC14 zum Einsatz.

Im Störungsfall, d.h. beim Absinken der positiven Betriebsspannung U+ und/oder beim Anstieg der negativen Betriebsspannung U-, wird der Stromfluß über den Widerstand R1 bzw. R2 unterbrochen, der Transistor T gesperrt und die Leuchtdiode LED erlischt. Hierdurch wird beispielsweise einer Bedienungsperson der Ausfall wenigstens einer der beiden Betriebsspannungen U+, U- signalisiert. Gleichzeitig wird im Störungsfall das Überwachungssignal Ü, insbesondere zum Rücksetzen von Mikroprozessoren oder zum Einleiten von Sicherungsmaßnahmen, ausgelöst. Die Ansprechschwellen für das Sperren des Transistors T und somit die Toleranzgrenzen für die Überwachung der Betriebsspannungen U+, U- sind über die Auswahl der Zenerdioden ZD1, ZD2 festlegbar.

## Patentansprüche

1. Schaltungsanordnung zum Überwachen von zwei Betriebsspannungen (U+, U-) unterschiedlicher Polarität, in der ein Transistor (T) vorgesehen ist, dessen Basis über eine erste Zenerdiode (ZD1) mit der positiven ersten Betriebsspannung (U+) und über einen ersten Widerstand (R1) mit der negativen zweiten Betriebsspannung (U-) verbunden ist, wobei der Kollektor des Transistors (T) mit einer Überwachungseinrichtung verbunden ist, die ein Überwachungssignal (Ü) abgibt,
dadurch gekennzeichnet, daß der Emitter des Transistors (T) über eine Reihenschaltung einer zweiten Zenerdiode (ZD2) und eines zweiten Widerstandes (R2) mit der negativen zweiten Betriebsspannung (U-) und über eine Diode (D) mit einem Bezugspotential (0V) verbunden ist.

2. Schaltungsanordnung nach Anspruch 1,
dadurch gekennzeichnet, daß der Kollektor des Transistors (T) über eine Reihenschaltung aus Widerständen (R3, R4) mit der ersten Betriebsspannung (U+) verbunden ist, wobei dem mit der Betriebsspannung (U+) verbundenen Widerstand (R4) eine Anzeigevorrichtung (LED) parallel geschaltet ist.

3. Schaltungsanordnung nach einem der Ansprüche 1 oder 2,
dadurch gekennzeichnet, daß die erste Betriebsspanung (U+) mit der Kathode der ersten Zenerdiode (ZD1) verbunden ist und daß die zweite Betriebsspannung (U-) über den zweiten Widerstand (R2) mit der Anode der zweiten Zenerdiode (ZD2) verbunden ist.

4. Schaltungsanordnung nach einem der Ansprüche 1 bis 3,
dadurch gekennzeichnet, daß die Zenerdioden (ZD1, ZD2) i Sperrichtung vorgespannt sind.

5. Schaltungsanordnung nach einem der Ansprüche 1 bis 4,
dadurch gekennzeichnet, daß die Überwachungseinrichtung als Inverter (1) ausgebildet ist.

6. Schaltungsanordnung nach einem der Ansprüche 1 bis 5,
dadurch gekennzeichnet, daß die Anzeigevorrichtung (LED) als Leuchtdiode ausgebildet ist.

## Claims

1. Circuit arrangement for monitoring a positive first operating voltage (U+) and a second negative operating voltage (U-), comprising a transistor (T) whose base is connected to the positive first operating voltage (U+) via a first zener diode (ZD1) and to the negative second operating voltage (U-) through a first resistor (R1), characterized in that the emitter of the transistor (T) is connected to the negative second operating voltage (U-) via a series connection of a second resistor (R2) and a second zener diode (ZD2), and to a reference potential (OV) via a diode (D).

2. Circuit arrangement as claimed in Claim 1, characterized in that the collector of the transistor (T) is connected to the first operating voltage (U+) via a series connection of resistors (R3, ∼4), an indicator (LED) being connected in parallel with the resistor (R4) connected to the operating voltage (U+).

3. Circuit arrangement as claimed in one of Claim 1 or 2, characterized in that the first operating voltage (U+) is connected to the cathode of the first zener diode (ZD1) and in that the second operating voltage (U-) is connected to the anode of the second zener diode (ZD2) through the second resistor (R2).

4. Circuit arrangement as claimed in one of the Claims to 3, characterized in that the zener diodes (ZD1, ZD2) are biased in on-conducting direction.

5. Circuit arrangement as claimed in one of the Claims to 4, characterized in that the monitoring device is arranged as an inverter (I).

6. Circuit arrangement as claimed in one of the Claims to 5, characterized in that the indicator (LED) is arranged as a light emitting diode.

## Revendications

1. Montage de circuit pour surveiller deux tensions de fonctionnement (U+, U-) de polarités différentes, comprenant un transistor (T) dont la base est connectée à la première tension de fonctionnement positive (U+) par l'intermédiaire d'une première diode Zener (ZD1) et à la deuxième tension de fonctionnement négative (U-) par l'intermédiaire d'une première résistance (R1), le collecteur du transistor (T) étant connecté à un dispositif de surveillance qui délivre un signal de surveillance (U), caractérisé en ce que l'émetteur du transistor (T) est connecté à la deuxième tension de fonctionnement négative (U-) par l'intermédiaire d'un montage en série comprenant une deuxième diode Zener (ZD2) et une deuxième résistance (R2) et à un potentiel de référence (OV) par l'intermédiaire d'une diode (D).

2. Montage de circuit suivant la revendication 1, caractérisé en ce que le collecteur du transistor (T) est connecté à la première tension de fonctionnement (U+) par l'intermédiaire d'un montage en série constitué par des résistances (R3, R4), un dispositif d'affichage (LED) étant monté en parallèle avec la résistance (R4) connectée à la tension de fonctionnement (U+).

3. Montage de circuit suivant la revendication 1 ou 2, caractérisé en ce que la première tension de fonctionnement (U+) est connectée à la cathode de la première diode Zener (ZD1) et la deuxième tension de fonctionnement (U-) est connectée à l'anode de la deuxième diode Zener (ZD2) par l'intermédiaire de la deuxième résistance (R2).

4. Montage de circuit suivant l'une quelconque des revendications 1 à 3, caractérisé en ce que les diodes Zener (ZD1, ZD2) sont polarisées dans le sens bloquant.

5. Montage de circuit suivant l'une quelconque des revendications 1 à 4, caractérisé en ce que le dispositif de surveillance est réalisé sous la forme d'un inverseur (I).

6. Montage de circuit suivant l'une quelconque des revendications 1 à 5, caractérisé en ce que le dispositif d'affichage (LED) est réalisé sous la forme d'une diode électroluminescente.
